# EUROPEAN PATENT APPLICATION

(11) **EP 4 340 316 A1**
(43) Date of publication of application: **20.03.2024**
(21) Application number: 22921466.3
(22) Date of filing: 10.08.2022
(51) Int. Cl.: H04L 43/50

(54) **COMMUNICATION LINK OPERATION CHARACTERISTIC TEST SYSTEM AND TEST METHOD**

(30) Priority: 19.01.2022 CN 202210059599
(71) Applicant: Shanghai Tosun Technology Ltd., Shanghai 201804 (CN)
(72) Inventor: LIU, Chu, Shanghai 201804 (CN); XIE, Yueyin, Shanghai 201804 (CN); MO, Mang, Shanghai 201804 (CN)
(74) Representative: Sun, Yanan
(86) International application number: PCT/CN2022/111593
(87) International publication number: WO 2023/138037

(57) **Abstract**

The present invention belongs to the field of communication testing technology, and specifically relates to a communication link operating characteristic testing system and a testing method thereof, wherein the communication link operating characteristic testing system includes: a relay combination circuit board, a simulation assembly and an interface assembly. The simulation assembly is arranged on the relay combination circuit board. The interface assembly is arranged on the relay combination circuit board, and the interface assembly is configured to connect with a DUT. The relays on the relay combination circuit board are turned on/off to connect the DUT to the required devices in the simulation assembly, so that the DUT can be tested under the working environment simulated by the simulation assembly. The present invention can cope with different working conditions, test and verify the various signal characteristics of the DUT and the operating characteristics of the DUT under various working conditions, which is applicable to various differential communication technologies and avoids negligence caused by manual testing.

## Description

### TECHNICAL FIELD

The present invention belongs to the technical field of communication testing, and in particular, relates to a communication link operating characteristic testing system and a testing method thereof.

### BACKGROUND

The existing common on-site communication technologies, such as Recommended Standard #485 (RS-485), Controller Area Network (CAN), FlexRay, and onboard Ethernet, adopt differential signaling at their interfaces. Differential signaling is a method for transmitting information using two complementary electrical signals. According to different communication technology principles, there are differences in their details and their electrical parameters, but twisted-pair cabling is typically used as the physical transmission medium, which can reduce the external interference and reduce the capacitive coupling and inductive coupling with the external interference source.

Due to the great differences in technical details and product application environments, research and development personnel commonly test a specific communication technology. However, the complex industrial and onboard on-site operating environment inevitably leads to common problems such as short circuit, open circuit, potential fluctuation, and waveform quality deterioration, in the communication process. Therefore, it is necessary to test the fault-tolerant capacity and signal characteristics of the product to find potential problems.

Therefore, based on the above technical problems, it is necessary to design a new communication link operating characteristic testing system and a testing method thereof.

### SUMMARY

The purpose of the present invention is to provide a communication link operating characteristic testing system and a testing method thereof.

In order to solve the above technical problems, the present invention provides a communication link operating characteristic testing system, including:
a relay combination circuit board,
a simulation assembly, wherein the simulation assembly is arranged on the relay combination circuit board; and
an interface assembly, wherein the interface assembly is arranged on the relay combination circuit board, and the interface assembly is configured for connecting a device under test (DUT).

The relays on the relay combination circuit board are turned on/off to connect the DUT to the devices required in the simulation assembly to test the DUT under the working environment simulated by the simulation assembly.

Further, the simulation assembly includes: a program-controlled oscilloscope, a multimeter, a waveform generator, a programmable power supply device, a four-quadrant waveform amplifier, a program-controlled adjustable resistance/capacitance load, and an external sub-link.

Further, the interface assembly includes:
an H_in interface, connected to a high level of a differential signal of a communication line of the DUT;
an L_in interface, connected to a low level of the differential signal of the communication line of the DUT;
a GND_in interface, connected to a communication GND of the DUT;
a DUT_BAT interface, connected to a power supply signal of the DUT; and
a DUT_GND interface, connected to a GND signal of the DUT.

In the second aspect, the present invention also provides a method for testing communication link operating characteristics using the above-mentioned communication link operating characteristic testing system, including:
determining a working environment required for a DUT; and
connecting corresponding devices according to the working environment to test the DUT.

Further, the method of connecting the corresponding devices according to the working environment to test the DUT includes:
when the working environment is for testing a normal working condition, simultaneously connecting a high-level signal of a differential signal of a communication line, a low-level signal of the differential signal of the communication line, and a communication GND signal of the DUT to an oscilloscope and a communication transceiver;
connecting the communication transceiver to an embedded controller;
connecting the embedded controller to an industrial personal computer (IPC), connecting a programmable power supply to a power supply signal and a GND signal of the DUT, and connecting the programmable power supply to the IPC.

At this time, the DUT is powered normally, and the DUT is powered by the programmable power supply. Further, the IPC communicates with the DUT through the embedded controller based on a differential communication link, and the oscilloscope extracts a waveform of the differential signal to obtain a network signal characteristic.

Further, the method of connecting the corresponding devices according to the working environment to test the DUT includes:
when the working environment is for testing a termination resistance, measuring, by a multimeter, the resistance between the H_in terminal and the GND, the resistance between the L_in terminal and GND, and the differential resistance.

The test types include: a power-off test and a power-on test.

During the power-off test, the DUT is not powered, and the resistance value is read through the multimeter;

During the power-on test, resistance R=(serial impedance value)*(voltage of H_in or L_in)/(voltage of DUT power supply signal - voltage of H_in or L_in).

Further, the method of connecting the corresponding devices according to the working environment to test the DUT includes:
when the working environment is for testing a short-circuit/open-circuit condition, setting the serial and parallel impedance devices to 0 S2, and switching the relays to realize the short-circuit condition between H_in/L_in and L_in/H_in, DUT_BAT, or DUT_GND, respectively; and
turning off the relays to realize the open-circuit condition of the H_in or L_in.

In the short-circuit and open-circuit conditions, the oscilloscope extracts operating characteristics to test the fault tolerance of the DUT.

Further, the method of connecting the corresponding devices according to the working environment to test the DUT includes:
When the working environment is for testing a common-mode/differential-mode interference condition, connecting the high-level signal of the differential signal of the communication line, the low-level signal of the differential signal of the communication line, and the communication GND signal of the DUT to the communication transceiver, and connecting the high-level signal of the differential signal of the communication line to the oscilloscope;
connecting the waveform follower module between the high-level signal and the low-level signal of the differential signal of the communication line of the DUT, and between the communication GND signal and the communication transceiver;
connecting the communication transceiver to the embedded controller; and
connecting the embedded controller to the IPC, connecting the programmable power supply to the power supply signal and the GND signal of the DUT, and connecting the programmable power supply to the IPC.

In this way, the waveform follower module is connected in series between the transceiver and the GND of the DUT to achieve a common-mode interference; and
the waveform follower module is connected in series between H_in and L_in to achieve a differential-mode interference.

In the common-mode interference and differential-mode interference conditions, the oscilloscope extracts the operating characteristics to test the fault tolerance of the DUT.

The advantages of the present invention are as follows. The present invention uses a relay combination circuit board, a simulation assembly and an interface assembly. The simulation assembly is arranged on the relay combination circuit board. The interface assembly is arranged on the relay combination circuit board, and the interface assembly is configured to connect with the DUT. The relays on the relay combination circuit board are turned on/off to connect the DUT to the required devices in the simulation assembly, so that the DUT can be tested under the working environment simulated by the simulation assembly. The present invention can cope with different working conditions, test and verify the various signal characteristics of the DUT and the operating characteristics of the DUT under various working conditions, which is applicable to various differential communication technologies and avoids negligence caused by manual testing.

Other features and advantages of the present invention will be described in the subsequent specification and will become apparent in part from the specification or understood through the implementation of the present invention. The objective and other advantages of the present invention are realized and obtained by the structure specifically pointed out in the specification and the drawings.

In order to make the above-mentioned objectives, features and advantages of the present invention more apparent and easier to understand, the preferred embodiments are provided below and described in detail in conjunction with the drawings.

### BRIEF DESCRIPTION OF THE DRAWINGS

In order to more clearly illustrate the specific embodiments of the present invention or the technical solution in the prior art, the drawings that need to be used in the specific embodiments or the description of the prior art will be briefly described below. Apparently, the drawings described below are some embodiments of the present invention, and for those having ordinary skill in the art, other drawings can be obtained according to these drawings without creative effort.
FIG. 1 is a schematic circuit diagram of the communication link operating characteristic testing system according to the present invention.
FIG. 2 is a schematic circuit diagram of testing under a normal working condition according to the present invention;
FIG. 3 is a schematic diagram of testing a termination resistance according to the present invention;
FIG. 4 is a schematic diagram of testing under a common-mode/differential-mode interference condition according to the present invention.

### DETAILED DESCRIPTION OF THE EMBODIMENTS

In order to clarify the objective, technical solution, and advantages of the embodiments of the present invention, the technical solution of the present invention will be described clearly and completely below in conjunction with the drawings. Apparently, the described embodiments are part of the embodiments of the present invention, not all embodiments. Based on the embodiments of the present invention, all other embodiments obtained by those having ordinary skill in the art without creative effort shall fall within the scope of protection of the present invention.

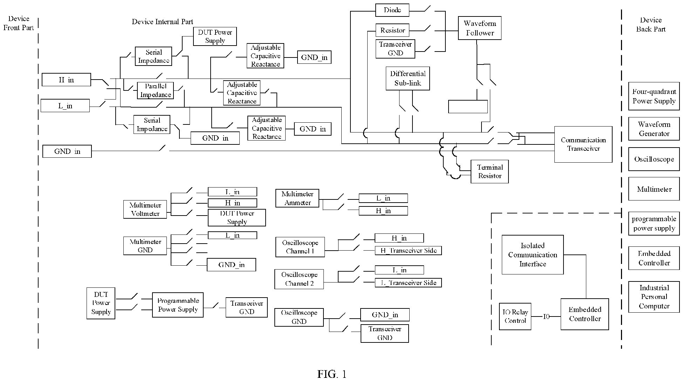

As shown in FIG. 1, this embodiment provides a communication link operating characteristic testing system, including: a relay combination circuit board, a simulation assembly, and an interface assembly. The simulation assembly is arranged on the relay combination circuit board. The interface assembly is arranged on the relay combination circuit board, and the interface assembly is configured for connecting the DUT. The relays on the relay combination circuit board are opened or closed to connect the DUT with the required devices in the simulation assembly, thereby testing the DUT in the working environment simulated by the simulation assembly, corresponding to different working conditions. In this way, the various signal characteristics of the DUT and the operating characteristics of the DUT under different working conditions are tested and verified, which is applicable to a variety of differential communication technologies and avoids negligence caused by manual testing. Through simulating various on-site abnormal operating conditions, the operator can acquire communication operating characteristics, and also verify the fault tolerance of the DUT under electrical failure cases such as connector aging and ground potential fluctuation, thereby providing a testing method for occasions with high safety requirements, avoiding negligence caused by manual testing and improving testing efficiency.

In this embodiment, the simulation assembly includes a program-controlled oscilloscope, a multimeter, a waveform generator, a programmable power supply, a four-quadrant waveform amplifier, a four-quadrant power supply, a program-controlled adjustable resistance/capacitance load, an external sub-link, and other special condition simulation devices.

In this embodiment, the test system is divided into the front part facing the DUT and the back part facing the standard measuring device. The interface assembly includes: the H_in interface connected to the high level of the differential signal of the communication line of the DUT, the L_in interface connected to the low level of the differential signal of the communication line of the DUT, the GND_in interface connected to the communication GND of the DUT, the DUT_BAT interface connected to the power supply signal of the DUT, and the DUT_GND interface is connected to the GND signal of the DUT.

In this embodiment, the specific circuit diagram is shown in FIG. 1. The H_in interface is connected to a serial impedance device through a relay and then connected to the power supply signal of the DUT. The H_in interface is connected to a parallel impedance device and another serial impedance device through relays. The H_in interface is connected to an adjustable capacitive reactance device through a relay, then connected to the GND_in interface, and connected to another adjustable capacitive reactance device through a relay. The L_in interface is connected to the serial impedance device and the parallel impedance device through relays, and the serial impedance device is connected to the GND_in interface through a relay. The L_in interface is connected to the adjustable capacitive reactance device through a relay and connected to the GND_in interface. The H_in interface and the L_in interface are connected to a communication transceiver through relays. The GND_in interface is connected to the communication transceiver through a relay. The H_in interface is connected to a diode through a relay and then connected to a waveform follower module through a relay. The L_in interface is connected to a resistor through the relay, and then is connected to the waveform follower module through a relay. The communication transceiver is connected to the waveform follower module through relays. The waveform follower module is connected to the GND_in interface and the communication transceiver through relays. The terminal resistor and the differential sub-link are connected to the communication transceiver. The voltmeter of the multimeter is connected to the H_in interface, the L_in interface and the power supply signal of the DUT through relays. The ammeter of the multimeter is connected to the H_in interface and the L_in interface through relays. The GND of the multimeter is connected to the L_in interface and the GND_in interface through relays. The channel 1 of the oscilloscope is connected to the H_in interface and the H transceiver side through relays. The channel 2 of the oscilloscope is connected to the L_in interface and the L transceiver side through relays. The GND of the oscilloscope is connected to the GND_in interface and the GND of the transceiver through relays. The power supply of the DUT is connected to the programmable power supply through a relay and then connected to the GND of the transceiver through a relay. The embedded controller is connected to the isolated communication interface and the IO relay control.

In this embodiment, a communication link operating characteristic testing method using the above-mentioned communication link operating characteristic testing system is further provided, including: determining the working environment required by the DUT; and connecting corresponding devices according to the working environment to test the DUT.

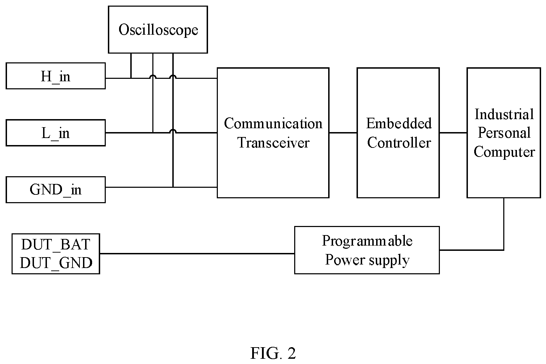

As shown in FIG. 2, in this embodiment, the method of connecting the corresponding devices according to the working environment to test the DUT includes: when the working environment is for testing a normal working condition, the high-level signal and low-level signal of the differential signal of the communication line of the DUT, and the communication GND signal are simultaneously connected to the oscilloscope and the communication transceiver. The communication transceiver is connected to the embedded controller. The embedded controller is connected to the industrial personal computer (IPC). Moreover, the programmable power supply is connected to the power supply signal and the GND signal of the DUT, and the programmable power supply is connected to the IPC. The communication transceiver is connected to the H_in interface, the L_in interface and the GND_in interface at the same time. At this time, the DUT is powered normally, and the DUT is powered by the programmable power supply. Further, the IPC communicates with the DUT through the embedded controller based on the differential communication link, and the oscilloscope extracts the waveform of the differential signal, to obtain the network signal characteristics, such as signal extremum, high/low value, waveform overshoot, rise/fall rates of signals, bit time accuracy, thereby verifying the consistency of the DUT. Based on the normal working condition, the correctness and robustness of communication operations, such as application layer data and network administration, can be verified through custom test scripts.

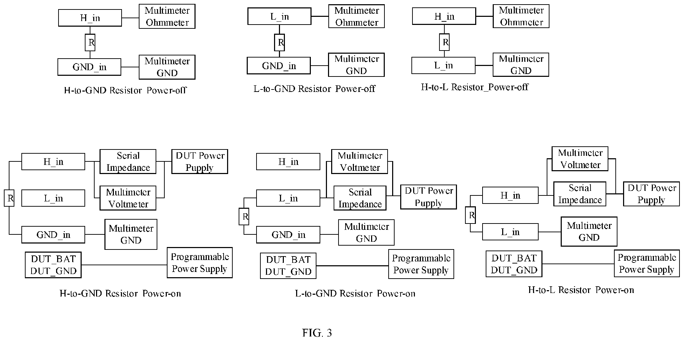

As shown in FIG. 3, in this embodiment, the method of connecting the corresponding devices according to the working environment to test the DUT includes: when the working environment is for testing a termination resistance, measuring, by a multimeter, the resistance between the H_in terminal and the GND, the resistance between the L_in terminal and GND, and the differential resistance. All testing types include: power-off testing and power-on testing. During the power-off testing, the DUT is not powered, and the multimeter reads the resistance value. During the power-on test, the resistance value R=(serial impedance value)*(voltage of H_in or L_in)/(voltage of DUT power supply signal - voltage of H_in or L_in). When H is powered off to the GND resistor, the H_in interface is connected to the ohmmeter of the multimeter, the GND_in interface is connected to the GND of the multimeter, the H_in interface and the GND_in interface are connected to the resistor R. When L is powered off to the GND resistor, the L_in interface is connected to the ohmmeter of the multimeter, the GND_in interface is connected to the GND of the multimeter, and the L_in interface and the GND_in interface are connected to the resistor R. When H is powered off to the L resistor, the H_in interface is connected to the ohmmeter of the multimeter, the L_in interface is connected to the GND of multimeter, the L_in interface and the H_in interface are connected to the resistor R. When H is powered on to the GND resistor, and the H_in interface is connected to the serial impedance device and then connected to the power supply signal of the DUT, the serial impedance device is connected to the voltmeter of the multimeter in parallel, the GND_in interface is connected to the GND of the multimeter, the resistor R is connected between the H_in interface and the GND_in interface, the DUT_BAT interface and the DUT_GND interface are connected to the programmable power supply. When L is powered on to the GND resistor, the L_in interface is connected the serial impedance device and then connected to the power supply signal of the DUT, the serial impedance device is connected to the voltmeter of the multimeter in parallel, the GND_in interface is connected to the GND of the multimeter, the resistor R is connected between the L_in interface and the GND_in interface, the DUT_BAT interface and DUT_GND interface are connected to the programmable power supply. When H is powered on to the L resistor, the H_in interface is connected to the serial impedance device and then connected to the power supply signal of the DUT, the serial impedance device is connected to the voltmeter of the multimeter in parallel, the L_in interface is connected to the GND of the multimeter, the resistor R is connected between the L_in interface and the H_in interface, and the DUT_BAT interface and DUT_GND interface are connected to the programmable power supply.

In this embodiment, the method of connecting the corresponding devices according to the working environment to test the DUT includes: when the working environment is for testing a short-circuit/open-circuit condition, the serial and parallel impedance devices are set to 0 Ω. When the relay is switched, the short circuit of H_in/L_in related to L_in/H_in, DUT_BAT, or DUT_GND can be achieved. When the relay is turned off, the open circuit of H_in or L_in can be achieved. In the short-circuit and open-circuit conditions, the oscilloscope extracts the operating characteristics to test the fault tolerance of the DUT.

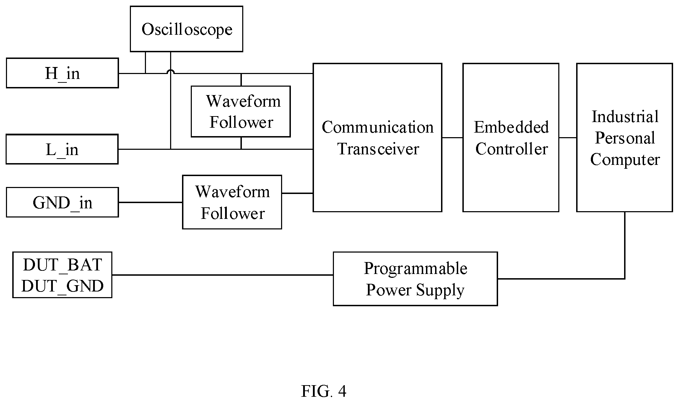

As shown in FIG. 4, in this embodiment, the method of connecting the corresponding devices according to the working environment to test the DUT includes: when the working environment is for testing a common mode/differential mode interference condition, the high-level signal and low-level signal of the differential signal of the communication line of the DUT, and the communication GND signal are connected to the communication transceiver. The high-level signal of the differential signal of the communication line is connected to the oscilloscope, and the H_in interface, the L_in interface and the GND_in interface are connected to the communication transceiver. The waveform follower module is connected between the high-level signal and the low-level signal of the differential signal of the communication line of the DUT, and between the communication GND signal and the communication transceiver. The communication transceiver is connected to the embedded controller and the embedded controller is connected to the IPC. Further, the programmable power supply is connected to the power supply signal of the DUT and the GND signal of the DUT, and the programmable power supply is connected to the IPC. In this way, the waveform follower module is connected in series between the transceiver and the GND of the DUT to achieve the common mode interference, and the waveform follower module is connected in series between H_in and L_in to achieve the differential mode interference. In the conditions of the common mode interference and the differential mode interference, the oscilloscope extracts the operating characteristics to test the fault tolerance of the DUT.

In this embodiment, the different tests can be combined according to test requirements, such as termination resistance verification → normal working condition → short-circuit/open-circuit fault introduction → normal working condition, in which the fault tolerance of the DUT under the short-circuit condition is verified; termination resistance verification → normal working condition → common-mode/differential-mode fault introduction → normal working condition, in which the interference resistance of the DUT under the signal interference fault condition is verified; termination resistance verification → normal working condition → short-circuit/open-circuit fault and common-mode/differential-mode fault simultaneous introduction → normal working condition → termination resistance verification, in which the interference resistance and the fault tolerance of the DUT under the complex fault condition are verified, and also the recovery ability of the electrical characteristics of the components after the fault is eliminated from the DUT. The method can cope with different working conditions, test and verify the various signal characteristics of the DUT and the operating characteristics of the DUT under various working conditions, which is applicable to various differential communication technologies and avoids negligence caused by manual testing.

In summary, the present invention uses a relay combination circuit board, a simulation assembly and an interface assembly. The simulation assembly is arranged on the relay combination circuit board. The interface assembly is arranged on the relay combination circuit board, and the interface assembly is configured to connect with the DUT. The relays on the relay combination circuit board are turned on/off to connect the DUT to the required devices in the simulation assembly, so that the DUT can be tested under the working environment simulated by the simulation assembly. The present invention can cope with different working conditions, test and verify the various signal characteristics of the DUT and the operating characteristics of the DUT under various working conditions, which is applicable to various differential communication technologies and avoids negligence caused by manual testing.

In several embodiments provided in the present invention, it should be understood that the device and method disclosed can also be implemented in other ways. The device embodiments described above are only schematic. For example, the flow chart and block diagram in the drawings show the possible architecture, functions and operations of devices, methods and computer program products according to multiple embodiments of the present invention. At this point, each box in the flow chart or block diagram may represent a part of a module, a program segment, or a code, and the part of the module, the program segment, or the code contains one or more executable instructions for implementing a specified logical function. It should also be noted that in some alternative implementations, the functions marked in the box may also occur in an order different from that indicated in the drawings. For example, two consecutive boxes can actually be executed basically in parallel, and they can sometimes be executed in the opposite order, which depends on the functions involved. It should also be noted that each box in the block diagram and/or flow chart, and the combination of blocks in the block diagram and/or flow chart, may be implemented by a dedicated hardware-based system that performs a specified function or action, or by a combination of dedicated hardware and computer instructions.

In addition, each functional module in each embodiment of the present invention can be integrated to form an independent part, or each module can exist independently, or two or more modules can be integrated to form an independent part.

If the function is implemented in the form of a software function module and sold or used as an independent product, it can be stored in a computer-readable storage medium. Based on this understanding, the technical solution of the present invention, in essence, is that the part that contributes to the prior art or a part of the technical solution can be reflected in the form of a software product. The computer software product is stored in a storage medium and includes a plurality of instructions to allow a computer device (such as a personal computer, a server, or network equipment, etc.) to perform all or part of the steps of the method described in each embodiment of the present invention. The aforementioned storage medium includes a USB flash drive, a mobile hard disk drive, a read-only memory (ROM), a random access memory (RAM), a magnetic disk, an optical disc, and other media that can store program codes.

Taking the above ideal embodiments according to the present invention as inspiration, through the above explanation content, those skilled in the art may make various changes and modifications without deviating from the scope of the technical idea of the present invention. The technical scope of the present invention is not limited to the contents of the specification, but must be determined according to the scope of the claims.

## Claims

1. A communication link operating characteristic testing system, comprising:
a relay combination circuit board,
a simulation assembly, wherein the simulation assembly is arranged on the relay combination circuit board; and
an interface assembly, wherein the interface assembly is arranged on the relay combination circuit board, and the interface assembly is configured for connecting a device under test (DUT); wherein
relays on the relay combination circuit board are turned on/off to connect the DUT to required devices in the simulation assembly to test the DUT under a working environment simulated by the simulation assembly.

2. The communication link operating characteristic testing system according to claim 1, wherein the simulation assembly comprises a program-controlled oscilloscope, a multimeter, a waveform generator, a programmable power supply device, a four-quadrant waveform amplifier, a program-controlled adjustable resistance/capacitance load, and an external sub-link.

3. The communication link operating characteristic testing system according to claim 1, wherein the interface assembly comprises:
an H_in interface, connected to a high level of a differential signal of a communication line of the DUT;
an L_in interface, connected to a low level of the differential signal of the communication line of the DUT;
a GND_in interface, connected to a communication GND of the DUT;
a DUT_BAT interface, connected to a power supply signal of the DUT; and
a DUT_GND interface, connected to a GND signal of the DUT.

4. A communication link operating characteristics testing method using the communication link operating characteristic testing system according to claim 1, comprising:
determining a working environment required for the DUT; and
connecting corresponding devices according to the working environment to test the DUT.

5. The communication link operating characteristics testing method according to claim 4, wherein a method of connecting the corresponding devices according to the working environment to test the DUT comprises:
when the working environment is for testing a normal working condition, simultaneously connecting a high-level signal of a differential signal of a communication line, a low-level signal of the differential signal of the communication line and a communication GND signal of the DUT to an oscilloscope and a communication transceiver;
connecting the communication transceiver to an embedded controller;
connecting the embedded controller to an industrial personal computer (IPC), connecting a programmable power supply to a power supply signal and a GND signal of the DUT, and connecting the programmable power supply to the IPC; wherein
at this time, the DUT is powered normally, and the DUT is powered by the programmable power supply; the IPC communicates with the DUT through the embedded controller based on a differential communication link, and the oscilloscope extracts a waveform of the differential signal to obtain a network signal characteristic.

6. The communication link operating characteristics testing method according to claim 4, wherein a method of connecting the corresponding devices according to the working environment to test the DUT comprises:
when the working environment is for testing a termination resistance, measuring, by a multimeter, a resistance between an H_in terminal and a GND, a resistance between an L_in terminal and GND, and a differential resistance;
all test types comprise a power-off test and a power-on test;
during the power-off test, the DUT is not powered, and a resistance value is read through the multimeter;
during the power-on test, resistance R=(serial impedance value)*(voltage of H_in or L_in)/(voltage of DUT power supply signal-voltage of H_in or L_in).

7. The communication link operating characteristics testing method according to claim 4, wherein a method of connecting the corresponding devices according to the working environment to test the DUT comprises:
when the working environment is for testing a short-circuit/open-circuit condition, setting serial and parallel impedances to 0 S2, and switching the relays to realize the short-circuit condition between H_in/L_in and L_in/H_in, DUT_BAT, or DUT_GND, respectively; and
turning off the relays to realize the open-circuit condition of the H_in or L_in;
in the short-circuit and open-circuit conditions, an oscilloscope extracts operating characteristics to test fault tolerance of the DUT.

8. The communication link operating characteristics testing method according to claim 4, wherein a method of connecting the corresponding devices according to the working environment to test the DUT comprises:
when the working environment is for testing a common-mode/differential-mode interference condition, connecting a high-level signal of a differential signal of a communication line, a low-level signal of the differential signal of the communication line and a communication GND signal of the DUT to a communication transceiver, and connecting the high-level signal of the differential signal of the communication line to an oscilloscope;
connecting a waveform follower module between the high-level signal and the low-level signal of the differential signal of the communication line of the DUT, and between the communication GND signal and the communication transceiver;
connecting the communication transceiver to an embedded controller; and
connecting the embedded controller to an IPC, connecting a programmable power supply to a power supply signal and a GND signal of the DUT, and connecting the programmable power supply to the IPC; wherein
the waveform follower module is connected in series between the transceiver and a GND of the DUT to achieve a common-mode interference;
the waveform follower module is connected in series between H_in and L_in to achieve a differential-mode interference; and
in the common-mode interference and differential-mode interference conditions, the oscilloscope extracts operating characteristics to test fault tolerance of the DUT.
